(19) Europäisches Patentamt
European Patent Office
Office européen des brevets

(11) Publication number: 0 350 326
A2

(12) # EUROPEAN PATENT APPLICATION

(21) Application number: 89306928.6

(22) Date of filing: 07.07.89

(51) Int. Cl.[5]: C 08 G 59/32
C 08 F 283/10, C 08 K 3/00,
H 01 L 23/29, C 08 L 51/08

(30) Priority: 07.07.88 JP 169780/88

(43) Date of publication of application:
10.01.90 Bulletin 90/02

(84) Designated Contracting States: DE FR GB IT NL

(71) Applicant: MITSUI TOATSU CHEMICALS, Inc.
2-5 Kasumigaseki 3-chome
Chiyoda-Ku Tokyo 100 (JP)

(72) Inventor: Machida, Koichi
262-32, Kamigo-cho Sakae-ku
Yokohama-shi Kanagawa (JP)

Kitahara, Mikio
2882, Iijima-cho Sakae-ku
Yokohama-shi Kanagawa (JP)

Kubo, Takayuki
1612, Kosugaya-cho Sakae-ku
Yokohama-shi Kanagawa (JP)

Torikai, Motoyuki
669, Kajigaya-cho Sakae-ku
Yokohama-shi Kanagawa (JP)

Asahina, Koutarou
5-45, Dai 4-chome
Kamakura-shi Kanagawa (JP)

(74) Representative: Stuart, Ian Alexander et al
MEWBURN ELLIS 2 Cursitor Street
London EC4A 1BQ (GB)

(54) **Resin compositions for sealing semiconductors.**

(57) A resin composition for sealing semiconductors which comprises (a) a modified epoxy resin composed of (i) a graft polymer of an epoxy resin having the structure (I);

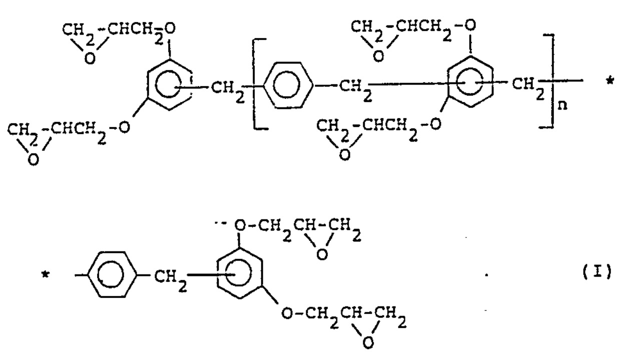

(I)

and a vinyl polymer and (ii) a soft vinyl-modified silicone polymer as particles having an average particle size of not more than 1.0 micron, which are uniformly dispersed in the graft polymer, (b) a hardening agent and (c) an inorganic filler, is herein provided. The resin composition for sealing semiconductors exhibits a low thermal expansion coefficient and a low elastic modulus, generates low stress when thermal shock is applied thereto and exhibits high heat resistance during soldering even after moisture absorption. Therefore, if the composition is used to seal large-scale semiconductor devices having high degree of integration or small-sized, thin semiconductors such as flat packages, these semiconductors provide high reliability.

EP 0 350 326 A2

**Description**

## RESIN COMPOSITIONS FOR SEALING SEMICONDUCTORS

The present invention relates to a resin composition for sealing semiconductor elements or devices (hereinafter simply referred to as "semiconductor(s)"). A preferred embodiment has a low elastic modulus and a low thermal expansion coefficient which does not adversely affect the heat resistance of the semiconductors, and which is excellent in thermal shock resistance and heat resistance during soldering and is therefore useful for sealing electronic parts such as semiconductors where high-reliability is required.

Recently, so-called plastic sealing methods using thermosetting resins represented by epoxy resins have been employed for sealing semiconductors. This is due to economic merits such as low price of the starting materials and ease of mass production. In particular, resins mainly used for sealing are resin compositions principally composed of polyfunctional epoxy resins, novolak type phenol resins and an inorganic filler because of their excellent heat resistance, moldability and electrical properties.

On the other hand, the degree of integration of semiconductor chips has been increased and correspondingly the chips have also been scaled up. Contrary to the scaling up of chips, there has been a tendency for the shape of the chip-containing packages to be made more compact and thinner as in the case of flat packages which is accompanied by changing to high density packaging on a substrate and surface mounting. For this reason, failures have occurred which have not been encountered with the conventional resins for sealing. More specifically, when thermal shock is applied, stress generated in the sealing resin due to the difference in the thermal expansion coefficients between the resin and the chip causes adverse phenomena such as the formation of cracks in the passivating film and cracks in the resin for sealing and a shift of aluminum wiring because of the scaling up of the chips and the reduction in thickness of the resin layer.

Moreover, since the package itself is exposed to a high temperature in a bath of solder during soldering, when surface mounting is performed, the moisture in the package is quickly evaporated. This in turn causes adverse phenomena such as the formation of cracks in the package, thereby lowering the humidity resistance of the semiconductors and hence reduction in the reliability thereof. Accordingly, it has been desired to develop resins for sealing semiconductors which have reduced stress and excellent heat resistance during soldering even after moisture absorption.

Stress generated in the chip is expressed by the product of the elasticity modulus of the resin and the difference in the thermal expansion coefficients between the resin and the chip. One method for reducing such stress is to make the thermal expansion coefficient of the resins small thereby minimizing the difference between the thermal expansion coefficient of the resin and a chip, but the difference is generally large and thus a large amount of inorganic fillers having a low thermal expansion coefficient must be incorporated into the resin to minimize such difference. A large amount of inorganic fillers has already been used practically in such a resin for sealing and, therefore, a further increase in the amount thereof would result in the deterioration of the moldability of the resulting resin composition. On the other hand, it has also been tried to use a plasticizer, a flexible epoxy resin or a phenol resin for the purpose of decreasing the elastic modulus of a resin to thus minimize the stress generated in a resin for sealing during thermal shock, but the hardened product obtained from these methods shows insufficient heat resistance.

Our Japanese Patent Un-examined Publication Nos. Sho 62-270617 and Sho 62-273222 disclose methods for reducing the stress generated in a resin composition during thermal shock while maintaining the desired heat resistance thereof, which comprise uniformly dispersing silicone polymer particles having an average particle size of not more than 1.0 micron in a graft polymer of an epoxy resin and a vinyl polymer. These methods are effective for lowering the stress, but they cannot completely solve the problem of heat resistance during soldering after moisture absorption. More specifically, cracks are formed in a package which absorbs water when it is exposed to an elevated temperature, such as those encountered with a bath of solder, which temperature is higher than the glass transition point of the sealing resin.

Accordingly, it would be advantageous to be able to provide a resin composition for sealing semiconductors which satisfactorily fulfills various requirements for resins that are suitable for sealing semiconductors such as integrated circuits having a high degree of integration where high reliability is required. Such requirements are, for instance, low stress generated in the resin for sealing and applied on the semiconductors, high thermal shock resistance and heat resistance during soldering even after moisture absorption.

The inventors of the present invention have conducted various studies to develop resins for sealing, have found that the foregoing advantageous effect may be achieved by uniformly dispersing fine particles of a soft vinyl-modified silicone polymer in a graft polymer of an epoxy resin having a specific structure and a vinyl polymer and thus have completed the present invention.

Consequently, according to the present invention, there is provided a resin composition for sealing semiconductors which comprises,

(a) a modified epoxy resin composed of (i) a graft polymer of an epoxy resin represented by the following general formula (I) and a vinyl polymer and (ii) a soft vinyl-modified silicone polymer particles having an average particle size of not more than 1.0 micron, which are uniformly dispersed in the graft polymer:

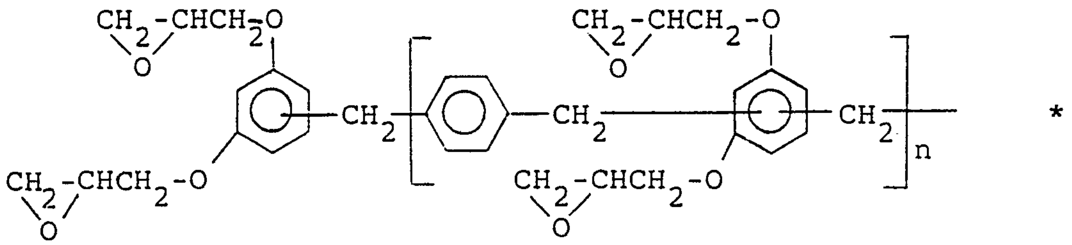

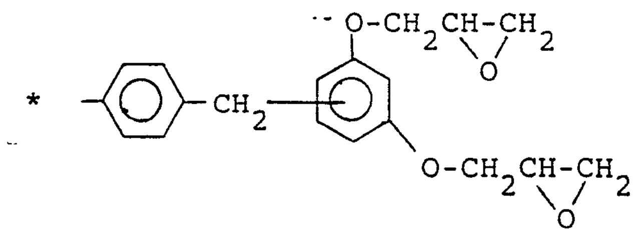

(I)

(in formula (I), n is an average ranging from 0 to 5);

(b) a hardening agent; and

(c) an inorganic filler.

In an embodiment of this invention, the epoxy resin represented by formula (I) used in the preparation of the component (a) can be obtained by subjecting resorcinol and α,α′-dialkoxy-p-xylene represented by the general formula (II):

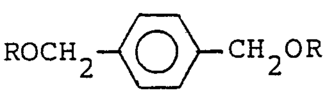

(II)

(in formula (II), R represents an alkyl group having up to 4 carbon atoms) to a dealcohol reaction in the presence of an acidic catalyst to thus form a resorcinol aralkyl resin represented by the general formula (III):

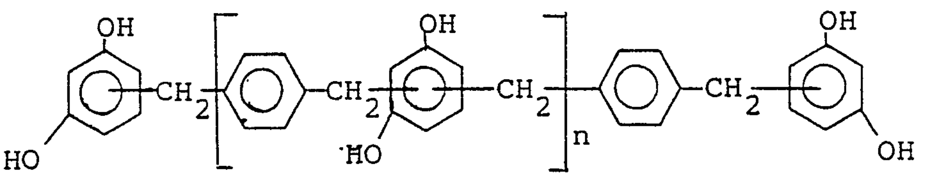

(III)

(in formula (III), n is an average ranging from 0 to 5) and then reacting the resorcinol aralkyl resin with epichlorohydrin in the presence of a hydrogen chloride acceptor.

In formula (I), if n averages more than 5, the viscosity of the epoxy resin becomes too high to easily perform melting kneading and transfer molding operations.

The epoxy resin is excellent in heat resistance because it is more polyfunctional than conventional phenol novolak type or cresol novolak type epoxy resins. In spite of the polyfunctionality, the epoxy resin is low in water absorption and high in flexibility of the molecular chain because p-xylene bonds are introduced into the skeleton of the epoxy resin.

The graft polymer of an epoxy resin represented by formula (I) and a vinyl polymer, which is used in the preparation of component (a) in the composition of this invention is typically prepared by polymerizing vinyl monomers in the presence of the foregoing epoxy resin to thus form the aforesaid vinyl polymer. Typical examples of vinyl monomers for obtaining the vinyl polymers include alkenyl aromatic compounds such as styrene and vinyl toluene; acrylic esters such as methyl methacrylate, dodecyl methacrylate, butoxyethyl methacrylate, glycidyl methacrylate, methyl acrylate, butyl acrylate, 2-ethylhexyl acrylate, hydroxyethyl acrylate trimethylolpropane triacrylate; acrylic compounds free of ester groups such as acrylonitrile, acrylic acid, butoxymethyl acrylamide and methacrylamide; non-conjugated vinyl compounds such as vinyl acetate, vinyl laurate, vinyl versatate, vinyl chloride, vinylidene chloride, ethylene and allyl acetate; and conjugated diene compounds such as butadiene, isoprene and chloroprene. It is also possible to use polymerizable vinyl compounds such as vinyl silicone, dibutyl fumarate, monomethyl maleate, diethyl itaconate and fluorine-containing compounds of acrylic and methacrylic acids, for instance, trifluoroethyl methacrylate and tetrafluoropropyl methacrylate. The amount of the vinyl monomers is not restricted to a specific value, but in general ranges from 1 to 50 parts by weight per 100 parts by weight of the epoxy resin.

To obtain vinyl polymers by polymerizing the aforesaid vinyl monomers, they are generally subjected to free radical polymerization in the presence of a free radical polymerization initiator of which typical examples

include a peroxide such as lauroyl peroxide, benzoyl peroxide tert-butyl perbenzoate, dimethyl dibenzoyl peroxyhexane, tert-butyl perpivalate, di-tert-butyl peroxide, 1,1-bis-tert-butylperoxy-3,3,5-trimethylcyclohexane, dimethyl di-tert-butyl peroxyhexane, tert-butyl cumyl peroxide, methyl ethyl ketone peroxide, cyclohexanone peroxide, cumene hydroperoxide, tert-butylperoxy allyl carbonate, dioctylperoxy dicarbonate, tert-butyl peroxymaleate, peroxysuccinic acid, tert-butyl peroxyisopropyl carbonate and hydrogen peroxide; and an azo compound as such azobisisobutyronitrile and azobisdimethyl valeronitrile. The amount of these free radical initiators used ranges from 0.1 to 10% by weight based on the weight of the vinyl monomer.

Alternatively, these vinyl monomers may be simultaneously subjected to a so-called redox polymerization optionally utilizing a reducing agent. A polymerization inhibitor such as hydroquinone and a chain transfer agent such as dodecyl mercaptan may also be used in such a polymerization.

It is also effective to introduce, into the epoxy resin, chemical bonds capable of undergoing graft polymerization such as polymerizable double bonds to promote the graft polymerization. Typically, the polymerizable double bonds can be introduced into the epoxy resin, for instance, by previously reacting the epoxy resin with a compound having both a functional group and a polymerizable double bond such as acrylic acid, acrylamide, methylol acrylamide, butoxymethyl acrylamide, hydroxymethyl methacrylate, glycidyl methacrylate, maleic anhydride, monoethyl itaconate, monobutyl fumarate, chloromethyl styrene, phosphoxyethyl methacrylate, chlorohydroxypropyl methacrylate, p-hydroxystyrene and dimethylaminoethyl methacrylate. When using such a compound simultaneously having a polymerizable double bond and a functional group, the amount thereof ranges from 0.1 to 10 parts by weight per 100 parts by weight of the epoxy resin.

In the present invention, some of the foregoing epoxy resin and the vinyl polymers may remain in the foregoing graft polymer in their free state without undergoing graft polymerization.

The modified epoxy resin used herein as the component (a) can be obtained by polymerizing monomers for forming the soft vinyl-modified silicone polymer in the presence of the graft polymer of the epoxy resin represented by formula (I) and the vinyl polymer, according to known techniques.

The soft vinyl-modified silicone polymer used in the composition of this invention may be a polymer based on vinyl modified silicone, having a glass transition temperature Tg of not higher than 20°C. The term "a polymer based on vinyl-modified silicone" herein means a homopolymer or copolymer of vinyl-modified silicones or a copolymer of a vinyl-modified silicone and one or more of other vinyl monomers. In the present invention, any commercially available vinyl-modified silicone can be used. Examples of the vinyl-modified silicone are methacryloxypropyl siloxanes represented by the general formula:

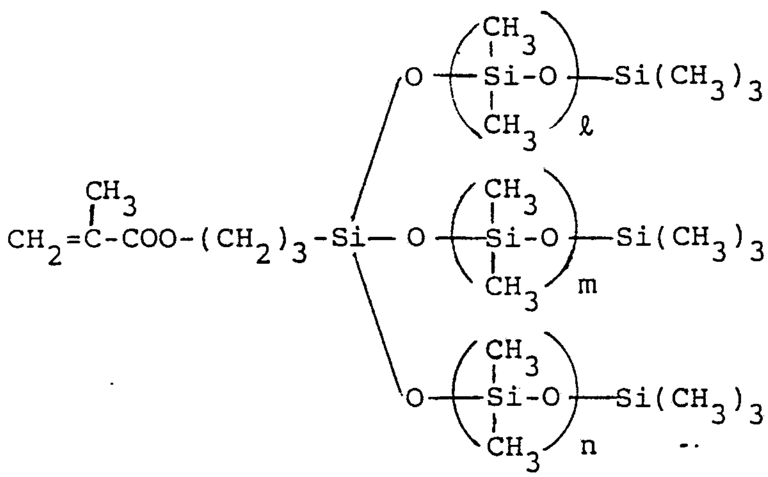

wherein, $0 \leqq \ell$, m, $n \leqq 1000$;
vinyl siloxanes represented by the general formula:

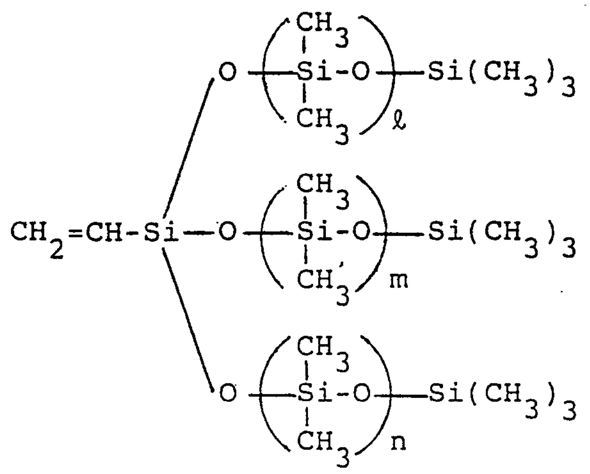

wherein, $0 \leqq \ell$, m, $n \leqq 1000$;
and functional silanes represented by the generalformula:
$R^1$-$Si(R^2)_3$
wherein $R^1$ represents methacryloxy, vinyl, allyl or allyloxy group and $R^2$ represents an alkyl and/or an alkoxy group. In addition, examples of other vinyl monomers are any of the monomers listed above in connection with the formation of the graft polymers. The amount of the vinyl monomer other than vinyl-modified silicones in the copolymer is such that the resulting copolymer becomes soft or is in a liquid or rubber-like state and that the average particle size thereof is not more than 1.0 micron. The amount of vinyl monomer varies depending on the kinds of monomers used, but in general the amount thereof is not more than 80% by weight on the basis of the total weight of the monomers used for forming such a copolymer.

To achieve the intended improvement in stress and heat resistance, the average particle size of the soft vinyl-modified silicone polymer should be not more than 1.0 micron, preferably not more than 0.5 micron and more preferably not less than 0.01 and not more than 0.2 micron. This is because if the average particle size of the soft vinyl-modified silicone polymer exceeds 1.0 micron, the intended effect of lowering the stress cannot be achieved and likewise the heat resistance is not improved. The control of the particle size of the soft viny-modified silicone polymer may be performed by appropriately selecting the kind and amount of the vinyl polymer from which the graft polymer is prepared together with the epoxy resin; and a specific monomer composition for forming the foregoing soft vinyl-modified silicone polymer as well as the number of the polymerizable double bonds to be introduced into the epoxy resin. The amount of a specific monomer used to form the foregoing soft vinyl-modified silicone polymer is not limited to a specific level, but in general it ranges from 1 to 100 parts by weight per 100 parts by weight of the epoxy resin.

It is easy to disperse the soft vinyl-modified silicone polymer in the graft polymer of the present invention composed of the epoxy resin and the vinyl polymer. Contrary to this, it is very difficult to disperse uniformly such a soft vinyl-modified silicone polymer having an average particle size of not more than 1.0 micron in an epoxy resin even if a silane coupling agent, modified silicone oil or the like is used.

The resin composition of the present invention contains a modified epoxy resin (component (a)) as an essential component. In this respect, the modified epoxy resin may optionally contain one or more of non-modified polyfunctional epoxy resins to control the amount of the soft vinyl-modified silicone polymer in the total resin composition at a desired level. Examples of the non-modified polyfunctional epoxy resins are glycidylates of compounds having at least two active hydrogen atoms in a molecule, such as polyhydric phenols, e.g., bisphenol A, bishydroxydiphenyl methane, resorcinol, bishydroxydiphenyl ether, bishydroxydiphenyl sulfone, phenol novolak, cresol novolak, brominated bisphenol A and brominated phenol novolak; polyhydric alcohols, e.g., ethylene glycol, neopentyl glycol, glycerin, trimethylolpropane, pentaerythritol, diethylene glycol, polypropylene glycol, bisphenol A-ethylene oxide adduct and trishydroxyethyl isocyanurate; amino compounds, e.g., ethylenediamine, aniline and 4,4′-diaminodiphenylmethane; glycidyl type epoxy resins obtained by reacting polyvalent carboxylic compounds e.g., adipic acid, phthalic acid and isophthalic acid with epichlorohydrin or 2-methyl-epichlorohydrin; and aliphatic (inclusive of alicyclic) epoxy resins, e.g., dicyclopentadiene diepoxide and butadiene dimer diepoxide. Moreover, the epoxy resins represented by formula (I) may also be used as such non-modified polyfunctional epoxy resins.

Those skilled in the art may easily determine the amount of the modified epoxy resin as the component (a) on the basis of the amount of the foregoing soft vinyl-modified silicone polymer required for the final resin composition for sealing semiconductors and that of the soft vinyl-modified silicone polymer contained in the modified epoxy resin.

Further, the amount of the soft vinyl-modified silicone polymer is desirably in the range of from 1 to 30% by weight and in particular 2 to 20% by weight on the basis of the sum of the amount of the component (a), the non-modified epoxy resin optionally employed and the component (b). This is because if it is less than 1% by weight, the intended improvement in stress may not be attained. On the other hand, if it is more than 30% by weight, not only flowability of the resin is lowered but its moldability may be impaired.

In the present invention, any conventional hardening agents can be used as the component (b). Examples of the hardening agent include novolak type phenol resins obtained by reacting phenols such as phenol or an alkylphenol with formaldehyde or paraformaldehyde as well as modified novolak type phenol resins, phenol aralkyl resins, resorcinol aralkyl resins and polyhydric phenols such as trihydroxyphenylmethane and tetrahydroxyphenylethane, commonly used amine type hardening agent such as diethylenetriamine, triethylenetetramine, isophoronediamine, diaminodiphenylmethane, diaminodiphenylsulfone, n-phenylenediamine and dicyandiamine and commonly used acid anhydrides such as phtharic anhydride, hexahydrophtharic anhydride, methyl nadic anhydride, pyromellitic dianhydride and benzophenonetetracarboxylic dianhydride. These hardening agents may be used alone or in combination.

The amount of the hardening agents to be incorporated in the composition may be from 0.1 to 10 and preferably 0.5 to 2.0 expressed in equivalent weight ratio based on the total amount of the modified epoxy resin (component (a)) and that of the non-modified epoxy resin optionally used.

Examples of the inorganic fillers used herein as component (c) include powders of crystalline silica, fused silicate, alumina, talc, calcium silicate, calcium carbonate, mica, clay, titanium white or the like; as well as glass fibers, carbon fibers or the like. These fillers may be employed alone or in combination, and generally powder of crystalline silica powder or fused silica powder is used alone or in combination from the viewpoint of their properties such as thermal expansion coefficient and thermal conductivity. These silicas are amorphous or spherical. The amount thereof to be incorporated into the composition preferably ranges from 100 to 800 parts by weight per 100 parts by weight of the sum of the components a), the non-modified epoxy resin optionally used and the component (b). If it is less than 100 parts by weight, the thermal expansion coefficient of the resulting resin composition is extremely high and good thermal shock resistance is not attained, while if it exceeds 800 parts by weight, the resulting resin composition is not practically acceptable since the flowability thereof is lowered and hence its moldability is greatly impaired.

The resin composition for sealing semiconductors of the present invention comprises, as essential components, (a) a modified epoxy resin composed of (i) a graft polymer of an epoxy resin represented by the general formula (I) and a vinyl polymer and (ii) soft vinyl-modified silicone polymer particles having an average particle size of not more than 1.0 micron, which are uniformly dispersed in the graft polymer; (b) a hardening agent; and (c) an inorganic filler as described above. However, it may further comprise, upon practical applications, other additives such a curing promotor as imidazoles, tertiary amines, quaternary ammonium salts, organometal compounds or organic phosphines; a releasing agent such as fatty acid amides, fatty acid salts or waxes; a flame retardant such as bromides, antimony or phosphorus; such a coloring agent such as carbon black; and/or a silane coupling agent, as optional components.

The resin composition according to the present invention can easily be obtained, as a material for molding, by sufficiently premixing the foregoing components, for instance, by means of a mixer, kneading the premix in a machine for melting and kneading it such as with heated rollers or a kneader, cooling the kneaded mixture to harden, and then pulverizing the hardened mixture.

The present invention will hereunder be explained in more detail with reference to the following Preparation Examples, Comparative Examples and Examples, but the invention is not restricted to these specific Examples. In the following Preparation Examples, Comparative Examples and Examples, the term "part" means "part by weight" unless otherwise specified.

Preparation Example 1: Preparation of Epoxy Resin

There were introduced 250 g (1.5 moles) of α,α′-dimethoxy-p-xylene, 1650 g (15 moles) of resorcinol and 8.3 g of p-toluenesulfonic acid into a reactor equipped with a stirrer, a thermometer and a Dean Stark trap for azeotropic distillation and the mixed solution was stirred while maintaining it at a temperature of 130 to 150° C. Methanol generated during the reaction was successively removed out of the system through the trap. The generation of methanol ceased in about 3 hours and thus the reaction was completed. Then the contents of the reactor was cooled to 50 to 60° C, followed by introducing 3000 g of methyl isobutyl ketone to dissolve them, further adding 1000 g of water thereto, stirring the mixture at 50 to 60° C for 30 minutes, allowing it to stand after stopping the stirring to cause phase-separation (the upper phase: organic phase; the lower phase: water phase) and eliminating the water phase to complete water washing. Then methyl isobutyl ketone and unreacted resorcinol, were distilled off under a reduced pressure to obtain 385 g of a resorcinol-aralkyl resin composition having the structure represented by the general formula (III). The composition of the resulting resin was examined by high performance liquid chromatography and the following results were obtained: 63.0 mole% ($n = 0$); 21.2 mole% ($n = 1$); 9.1 mole% ($n = 2$); and 6.7 mole% ($n \geqq 3$). Moreover, the softening point (determined according to JIS,K-2548) of this resin was found to be 75° C.

There was mixed 385 g of the resorcinol-aralkyl resin and 1100 g (11.9 moles) of epichlorohydrin and the mixture was introduced into a reactor provided with a stirrer, a Dean Stark azeotropic distillation trap and a dropping funnel. The temperature of this mixture was raised to 115 to 119° C with stirring, followed by dropwise adding 550 g of 40% aqueous solution of sodium hydroxide at that temperature over 4 hours with successive separating and recovering water distilled off therefrom and returning the epichlorohydrin phase to the reactor. After the dropwise addition, the reaction was completed because of the removal of water distilled off during the addition. Thereafter, excess epichlorohydrin was distilled off under a reduced pressure, followed by dissolving the reaction products in 1500 g of methyl isobutyl ketone, then filtering off a slight excess of sodium chloride and sodium hydroxide and removing the solvent by distillation under a reduced pressure to thus

obtain 445 g of an epoxy resin as an orange-colored oily material. The epoxy equivalent of this resin was 159 g/eq. and the softening point thereof was 42°C.

Preparation Example 2: Preparation of Modified Epoxy Resin

100 Parts of an epoxy resin obtained in the preparation example 1, 10 parts of toluene and one part of methacrylic acid were reacted with each other at 120 to 125°C for 2 hours in the presence of tetradecyl dimethyl benzyl ammonium chloride and then 3.6 parts of butyl acrylate, 0.1 part of glycidyl methacrylate and 0.05 part of t-butylperoxy-2-ethylhexanoate were added to the foregoing reaction mixture to further perform a reaction at 100°C for one hour. Further, the reaction was continued for 4 hours while dropwise adding continuously 30 parts of methacryloxypropyl siloxane available from SHINETSU CHEMICAL Co., Ltd., 0.6 parts of neopentyl glycol diacrylate and 0.15 part of 1,1-bis(t-butylperoxy)-3,3,5-tricyclohexane, followed by continuing the reaction for additional 4 hours, removing the solvent under a reduced pressure to thus obtain a modified epoxy resin (a-1) (epoxy equivalent = 225) containing particles of a soft vinyl-modified silicone polymer having an average particle size of 0.35 micron dispersed therein.

Preparation Example 3

The same procedures used in Preparation Example 2 were repeated except that methacrylic acid and butyl acrylate were used in amounts of 1.5 part and 5 parts respectively to thus obtain a modified epoxy resin (a-2) (the epoxy equivalent thereof = 228) in which soft vinyl-modified silicone polymer particles having an average particle size of 0.1 micron were dispersed.

Preparation Example 4

The same procedures used in Preparation Example 2 were repeated except that methacrylic acid and butyl acrylate were used in amounts of 0.5 part and 2 parts respectively to thus obtain a modified epoxy resin (a-3) (the epoxy equivalent thereof = 221) in which soft vinyl-modified silicone polymer particles having an average particle size of 1 micron were dispersed.

Preparation Example 5

The same procedures used in Preparation Example 2 were repeated except that 15 parts of methacryloxypropyl siloxane and 15 parts of 2-ethylhexyl acrylate were substituted for 30 parts of methacryloxypropyl siloxane to thus obtain a modified epoxy resin (a-4) (the epoxy equivalent thereof - 225) in which soft vinyl-modified silicone polymer particles having an average particle size of 0.35 micron were dispersed.

Comparative Preparation Example 1

100 Parts of an o-cresol-novolak epoxy resin (epoxy equivalent = 217) available from NIPPON KAYAKU Co., Ltd., 10 parts of toluene and one part of methacrylic acid were reacted with each other at 120 to 125°C for 2 hours in the presence of tetradecyl dimethyl benzyl ammonium chloride and then 3.6 parts of butyl acrylate, 0.1 part of glycidyl methacrylate and 0.05 part of t-butylperoxy-2 ethylhexanoate were added to the foregoing reaction mixture to further perform a reaction at 100°C for one hour. Further, the reaction was continued for 4 hours while dropwise adding continuously 30 parts of methacryloxypropyl siloxane, 0.6 part of neopentyl glycol diacrylate and 0.15 part of 1,1-bis(t-butylperoxy)-3,3,5-tricyclohexane, followed by continuing the reaction for additional 4 hours and removing the solvent under a reduced pressure to thus obtain a modified epoxy resin (a-5) (epoxy equivalent = 295) containing particles of a soft vinyl-modified silicone polymer having an average particle size of 0.35 micron dispersed therein.

Examples 1 to 5 and Comparative Examples 1 and 2

Resin compositions for molding were prepared by melting and mixing blends having compositions (part by weight) as shown in the following Table 1 at a temperature of 110 to 120°C for 5 minutes with heated rollers, cooling the melt blend to harden it pulverizing the hardened blend and compressing the pulverized resin composition.

From these compositions, 100-pin flat packages (20 mm x 30 mm x 2.5 mm) provided thereon with an element (10 mm x 10 mm) for testing and test pieces for determining physical properties were formed according to a transfer molding technique and then were subjected to post-hardening at 180°C for 6 hours. The results of the tests are summarized in Tables 1 and 2 given below.

Table 1

| Component | ex.1 | ex.2 | ex.3 | ex.4 | ex.5 | Comp.ex.1 | Comp.ex.2 |
|---|---|---|---|---|---|---|---|
| Epoxy resin *1) | 56 | | 56 | 56 | 56 | | |
| Epoxy resin *2) | | | | | | 56 | 100 |
| Modified epoxy resin (a-1) | 44 | 100 | | | | | |
| Modified epoxy resin (a-2) | | | 44 | | | | |
| Modified epoxy resin (a-3) | | | | 44 | | | |
| Modified epoxy resin (a-4) | | | | | 44 | | |
| Modified epoxy resin (a-5) | | | | | | 44 | |
| Novolak resin *3) | 41 | 41 | 41 | 41 | 41 | 41 | 41 |
| Soft vinyl-modified silicone polymer | 10 | 22 | 10 | 10 | 10 | 10 | |
| Average particle size of soft vinyl-modified silicone polymer | 0.35 | 0.35 | 0.1 | 1.0 | 0.35 | 0.35 | |
| Fused silica | 400 | 400 | 400 | 400 | 400 | 400 | 400 |
| Triphenyl phosphine | 0.6 | 0.6 | 0.6 | 0.6 | 0.6 | 0.6 | 0.6 |
| Silane coupling agent | 4 | 4 | 4 | 4 | 4 | 4 | 4 |
| Carbon black | 2 | 2 | 2 | 2 | 2 | 2 | 2 |
| Carnauba wax | 2.5 | 2.5 | 2.5 | 2.5 | 2.5 | 2.5 | 2.5 |

*1): The epoxy resin obtained in the preparation example 1.
*2): o-Cresol-novolak epoxy resin, EOCN 1020 (available from NIPPON KAYAKU Co.,Ltd.)
*3): Phenol-novolak, PN (available from NIPPON KAYAKU Co.,Ltd.)

Table 2

| | ex.1 | ex.2 | ex.3 | ex.4 | ex.5 | Comp.ex.1 | Comp.ex.2 | Test Method |
|---|---|---|---|---|---|---|---|---|
| Glass Transition Point (℃) | 185 | 185 | 185 | 185 | 185 | 160 | 160 | TMA Method |
| Thermal Expansion Coef. ($\times 10^{-5}$℃$^{-1}$) | 1.9 | 1.9 | 1.9 | 1.9 | 1.9 | 2.0 | 2.0 | TMA Method |
| Flexural Strength ($kg/mm^2$) | 14.5 | 14.0 | 14.5 | 14.5 | 14.5 | 14.5 | 16.0 | JIS K 6911 |
| Flexural Modulus ($kg/mm^2$) | 1100 | 1000 | 1100 | 1100 | 1100 | 1100 | 1400 | JIS K 6911 |
| Alumislide ($\mu$) | 2 | 2 | 2 | 2 | 3 | 5 | 25 | (1) |
| V.P.S. Test | 0/20 | 0/20 | 0/20 | 0/20 | 0/20 | 5/20 | 20/20 | (2) |

(1) Alumislide: Shift of a bonding pad portion (100 microns x 100 microns) at the corner of the test element observed after repeating, 1000 times, cooling (for 30 minutes at -65°C)-heating (for 30 minutes at 150°C) cycles.

(2) V.P.S. Test: The package was held, for 24 hours, in a Pressure-Cooker Tester maintained at 121°C and 2 atms. and immediately thereafter was introduced into FLUORINATO (available from SUMITOMO 3M Co., Ltd.: FC-70) to count the number of test pieces which caused cracking. The numerator is the number of test pieces causing cracking and the denominator is the total number of the test pieces.

As has been explained above with reference to Examples and Comparative Examples, the resin composition for sealing semiconductors according to the present invention has a low thermal expansion coefficient and a low elastic modulus, generates low stress when thermal shock is applied thereto and exhibits high heat resistance during soldering even after moisture absorption. Therefore, if the composition is used to seal large-scale semiconductor devices having high degree of integration or small-sized, thin semiconductors such as flat packages, these semiconductors provide high reliability. Thus, the present invention is highly industrially useful.

## Claims

1. A resin composition for sealing semiconductors which comprises components :-

(a) a modified epoxy resin composed of (i) a graft polymer of an epoxy resin represented by the following general formula (I) and a vinyl polymer and (ii) soft vinyl-modified silicone polymer particles having an average particle size of not more than 1.0 micron, which are uniformly dispersed in the graft polymer:

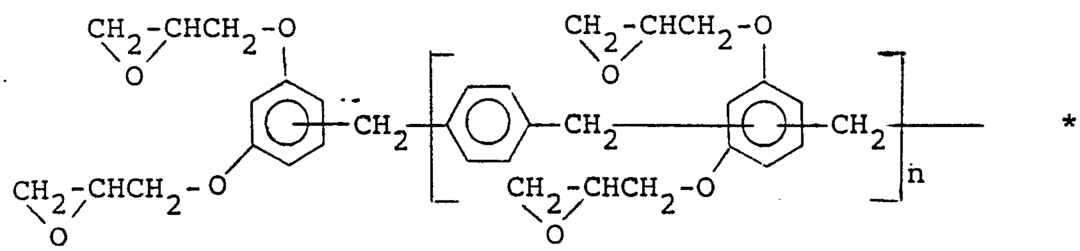

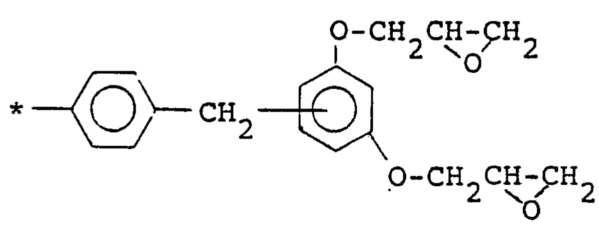

(I)

(in formula (I), n has an average value ranging from 0 to 5);

(b) a hardening agent; and

(c) an inorganic filler.

2. The resin composition for sealing semiconductors of claim 1 wherein a vinyl monomer used to prepare the vinyl polymer is an acrylic ester.

3. The resin composition for sealing semiconductors of claim 1 or 2 wherein the amount of the vinyl polymer in the graft polymer of the epoxy resin and the vinyl polymer ranges from 1 to 50 parts by weight per 100 parts by weight of the epoxy resin.

4. The resin composition for sealing semiconductors of any preceding claim wherein the soft vinyl-modified silicone polymer is selected from homopolymers and copolymers of vinyl-modified silicones and copolymers of the vinyl-modified silicones and other vinyl monomers.

5. The resin composition for sealing semiconductors of claim 4 wherein the vinyl-modified silicone is a methacryloxypropyl siloxane represented by the general formula:

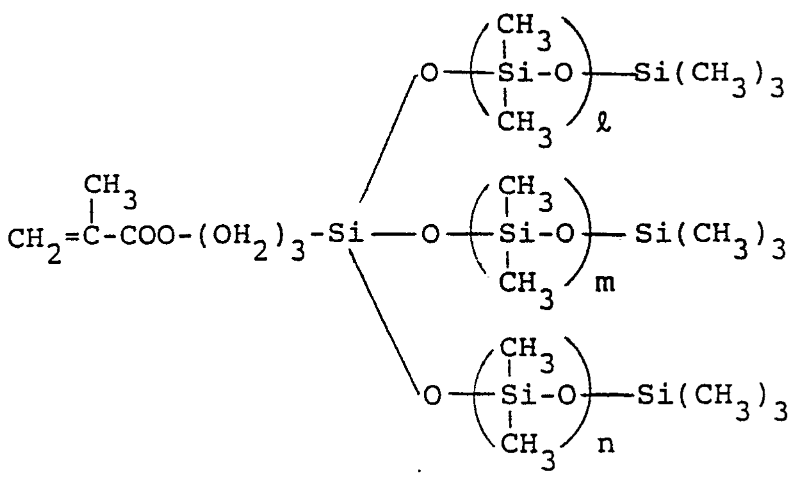

wherein $0 \leqq \ell, m, n \leqq 1000$;

6. The resin composition for sealing semiconductors of claim 4 or 5 wherein the amount of the vinyl-modified silicone ranges from 1 to 100 parts by weight per 100 parts by weight of the epoxy resin.

7. The resin composition for sealing semiconductors of any preceding claim wherein the average particle size of the soft vinyl-modified silicone polymer is not more than 0.5 micron.

8. The resin composition for sealing semiconductors of any preceding claim wherein the hardening agent is novolak phenol resin.

9. The resin composition for sealing semiconductors of any preceding claim wherein the amount of the hardening agent ranges from 0.1 to 10 expressed in equivalent weight ratio based on the total mount of the modified epoxy resin and the non-modified epoxy resin optionally used.

10. The resin composition for sealing semiconductors of any preceding claim wherein the inorganic filler is crystalline and/or fused silica.

11. The resin composition for sealing semiconductors of any preceding claim wherein the amount of the inorganic filler ranges from 100 to 800 parts by weight per 100 parts by weight of the sum of the modified epoxy resin, the non-modified epoxy resin optionally used and the hardening agent.

12. A process for preparing a resin composition for sealing semiconductors which comprises polymerizing a vinyl monomer in the presence of an epoxy resin represented by the following general formula (I) to thus form a graft polymer of the epoxy resin and a vinyl polymer, polymerizing a monomer for forming a sof vinyl-modified silicone polymer in the presence of the graft polymer to thus form a modified epoxy resin composed of the graft polymer and the soft vinyl-modified silicone polymer as particles having an average particle size of not more than 1.0 micron, which are uniformly dispersed in the graft polymer, mixing the modified epoxy resin, a hardening agent and an inorganic filler and further optional component(s), melting and kneading the mixture, cooling the kneaded mixture to harden, and then pulverizing the hardened mixture:

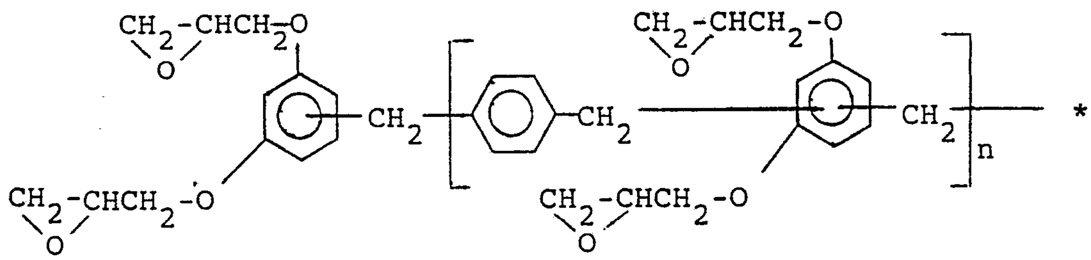

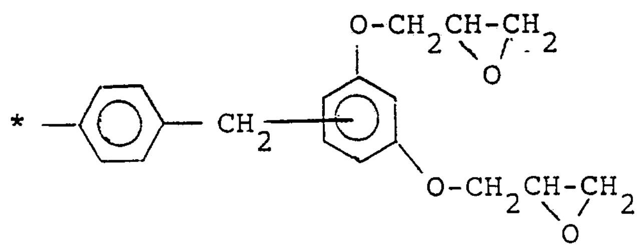

(in formula (I), n has an average value ranging from 0 to 5).

13. The process for preparing the resin composition for sealing semiconductors of claim 12 wherein the amount of the vinyl monomer used ranges from 1 to 50 parts by weight per 100 parts by weight of the epoxy resin.

14. The process for preparing the resin composition for sealing semiconductors of claim 12 or 13 wherein the amount of the monomer used for forming the soft vinyl-modified silicone polymer ranges from 1 to 100 parts by weight per 100 parts by weight of the epoxy resin.

15. The process for preparing the resin composition for sealing semiconductors of claim 12, 13, or 14 wherein the amount of the hardening agent used ranges from 0.1 to 10 expressed in equivalent weight ratio based on the total amount of the modified epoxy resin and the non-modified epoxy resin optionally used.

16. The process for preparing the resin composition for sealing semiconductors of claim 12,13,14 or 15 wherein the amount of the inorganic filler used ranges from 100 to 800 parts by weight per 100 parts by weight of the sum of the modified epoxy resin, the non-modified epoxy resin optionally used and the hardening agent.